# EUROPEAN PATENT APPLICATION

(11) **EP 4 738 619 A1**
(43) Date of publication of application: **06.05.2026**
(21) Application number: 24460033.4
(22) Date of filing: 30.10.2024
(51) Int. Cl.: H01R 13/53, H01R 13/41

(54) **HV CONNECTOR FOR INDUSTRIAL POWER EQUIPMENT**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

High voltage connector (1,11)
for an industrial power equipment configured to lead high current and withstand high voltage in particular usable for a plasma process equipment,
the HV connector (1,11) is formed to fit into a corresponding plug (121) and comprises:
- a plug-connecting-end (69 and an inner-end (7),
- a connecting element (2),
- an insulator body (3) surrounding the connecting element (2) at least partially,
- the connecting element (2) having a rod shape which expands from the plug-connecting-end (6 to an inner-end (7), the connecting element (2) comprises a rod-diameter-changing-point 8, where the diameter of the connecting element (2) changes from a first rod-diameter (21) in direction to the plug-connecting-end (6) to a second rod-diameter (22) in direction to the inner-end (7),
- the insulator body (3) having a shape with a hole (23), the hole (23) formed to surround the connecting element (2), the hole (23) having a hole-diameter-changing-point (9), where the hole-diameter of the hole (23) changes from a first hole-diameter (24) in direction to the plug-connecting-end (6) to a second hole-diameter (25) in direction to the inner-end (7), wherein the first hole-diameter (24) is equal to the first rod-diameter (21) and the second hole-diameter (25) is equal to the second rod-diameter (22), so that the insulator-body (3) fits tightly on the connecting element (2), and
- the insulator body (3) is positioned in such a way that its hole-diameter-changing-point (9) is adjacent to the rod-diameter-changing-point (8) of the connecting element (2), so that the connecting element (2) and the insulator body (3) build a compound without free distance at both diameters.

## Description

The invention relates to industrial power equipment and a high voltage connector for such industrial power equipment. One special industrial power equipment is plasma process equipment. Plasma process equipment shall mean a plasma power supply, a plasma chamber, a plasma electrode, or a impedance matching network, a measuring equipment, or a combiner or splitter, placed between a plasma power supply, a plasma chamber, e.g.. Plasma process shall mean processing such as deposition or etching of parts, e.g. semiconductor parts, with a plasma processing such as sputtering, PVD, PECVD, plasma spray, and/or similar processes.

Many modern semiconductor chip fabrication processes include generation of a plasma from which ions and/or radical constituents are derived for use in either directly or indirectly affecting a change on a surface of a substrate exposed to the plasma. For example, various plasma-based processes can be used to etch material from a substrate surface, deposit material onto a substrate surface, or modify a material already present on a substrate surface. The plasma is often generated by applying radiofrequency (RF) or HV DC power or HV DC pulsed power to a process gas in a controlled environment, such that the process gas becomes energized and transforms into the desired plasma. The characteristics of the plasma are affected by many process parameters including, but not limited to, material composition of the process gas, flow rate of the process gas, geometric features of the plasma generation region and surrounding structures, temperatures of the process gas and surrounding materials, frequency of the RF or pulsed HV power applied, and magnitude of the power applied, among others. Various plasma process equipment must be connected with cables. Those cables are typically connected with plugs at the cables and corresponding connectors at the cabinets of the plasma process equipment. Such connectors and plugs have sometimes high challenges related to current they must lead and voltage they must withstand. Often the combination of the cabinets and the connectors mounted at the cabinets is also a challenge. When HV and HF comes together, those challenges rise.

"HV" shall be the abbreviation for high voltage. High voltage shall mean voltages about 8 kV or more, in particular about 15 kV or more, preferred about 29 kV or more. Plasma process equipment uses such HV in an increasing number of equipment due to the rising challenges in semiconductor industry.

High current shall mean current about 10 A or more, in particular about 100 A or more, preferred about 1 kA or more. High power and therefore these high amounts of current are also more and more a wanted feature of such equipment due to the rising challenges in semiconductor industry.

In this application, "HF" or "RF" stands for radio frequency. Radio frequency here means a frequency of at least 1 MHz.

Preferably, this also means a frequency of no more than 100 MHz.

Such industrial process arrangements are often operated at a very high performance. Very high power here means an electrical output power of at least 10 kW.

It is a task to build a HV connector for industrial power equipment that withstands high voltage and is reliable in this industrial power equipment, especially in plasma process equipment.

The task will be solved by a HV connector according to claim 1. Further aspects are disclosed in the description and in all other claims.

In one aspect the HV connector is configured to lead high current and withstand high voltage and is, in particular usable for a plasma process equipment.

The HV connector is formed to fit into a corresponding plug.

The HV connector comprises:
- a plug-connecting-end and an inner-end,
- a connecting element,
- an insulator body surrounding the connecting element at least partially,
- the connecting element having a rod shape which expands from the plug-connecting-end to an inner-end, the connecting element comprises a rod-diameter-changing-point, where the diameter of the connecting element changes from a first rod-diameter in direction to the plug-connecting-end to a second rod-diameter in direction to the inner-end,
- the insulator body having a shape with a hole, the hole formed to surround the connecting element, the hole having a hole-diameter-changing-point, where the hole-diameter of the hole changes from a first hole-diameter in direction to the plug-connecting-end to a second hole-diameter in direction to the inner-end, wherein the first hole-diameter is equal to the first rod-diameter and the second hole-diameter is equal to the second rod-diameter, so that the insulator-body fits tightly on the connecting element, and
- the insulator body is positioned in such a way that its hole-diameter-changing-point is adjacent to the rod-diameter-changing-point of the connecting element, so that the connecting element and the insulator body build a compound without free distance at both diameters.

"Diameter-changing-point" should be understood to be a place which may be larger than a spot. It could be an area, a volume, where the diameter of a hole or a rod changes. The change may be abruptly or during a certain length, e.g. in a conus way.

In such a way, the connector may be designed to manage high currents and withstand high voltages, making it suitable for demanding industrial applications like plasma processing. The design may ensure that the connector fits securely into the corresponding plug, which can enhance safety and reliability during operation. With the insulator body that partially surrounds the connecting element, the design provides robust insulation, reducing the risk of electrical discharge and improving overall safety. The diameter of the connecting element and the insulator body is matched precisely at the rod-diameter-changing-point and hole-diameter-changing-point, ensuring a tight fit without free distance. This can enhance durability and prevent electrical losses or arcing. It may also be tight against liquid inside the industrial power equipment like plasma power equipment. The arrangement where the insulator body is adjacent to the rod-diameter-changing-point of the connecting element ensures that the two components form a stable compound, reducing the risk of detachment or misalignment during use. So, these features collectively enhance the performance, safety, and reliability of the high voltage connector in industrial applications.

Other aspects and advantages of the invention will become more apparent from the following detailed description, taken in conjunction with the accompanying drawings, illustrating by way of example the present invention.

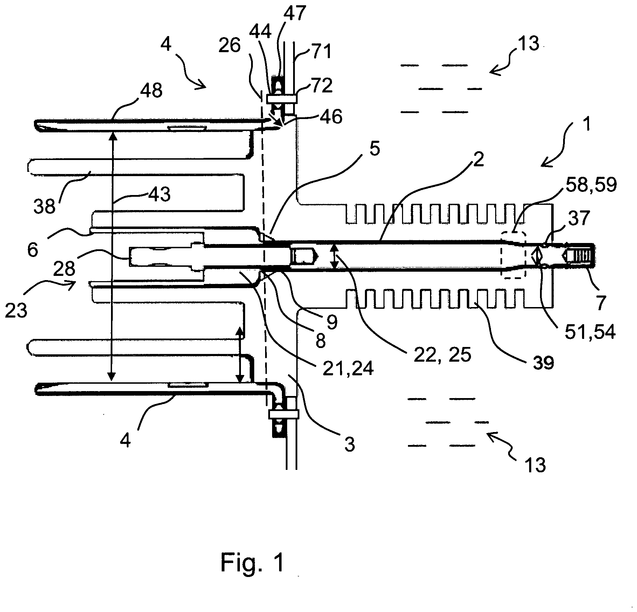

Fig. 1 shows a section view of a HV connector with one connecting element.
Fig. 2 shows a section view of a HV connector with two connecting elements.
Fig. 3 shows a section view of a HV connector with two connecting elements and a corresponding plug.
Fig. 4 shows a exploded view of a HV connector with two connecting elements and a corresponding plug.
Fig. 5 shows a first embodiment of an electronic device;
Fig. 6 shows a view of a HV connector mounted on a cabinet of a industrial equipment.
Fig. 7 shows a plasma processing system with a plasma chamber.

The HV connector 1 is configured for an industrial power equipment configured to lead high current and withstand high voltage in particular usable for a plasma process equipment. The HV connector 1 comprises a plug-connecting-end 6 and an inner-end 7, as well as a connecting element 2, and an insulator body 3 surrounding the connecting element 2 at least partially.

The connecting element 2 having a rod shape which expands from the plug-connecting-end 6 to an inner-end 7, the connecting element 2 comprises a rod-diameter-changing-point 8, where the diameter of the connecting element 2 changes from a first rod-diameter 21 in direction to the plug-connecting-end 6 to a second rod-diameter 22 in direction to the inner-end 7.

The insulator body 3 having a shape with a hole 23, the hole 23 formed to surround the connecting element 2, the hole 23 having a hole-diameter-changing-point 9, where the hole-diameter of the hole 23 changes from a first hole-diameter 24 in direction to the plug-connecting-end 6 to a second hole-diameter 25 in direction to the inner-end 7, wherein the first hole-diameter 24 is equal to the first rod-diameter 21 and the second hole-diameter 25 is equal to the second rod-diameter 22, so that the insulator-body 3 fits tightly on the connecting element 2.

The insulator body 3 is positioned in such a way that its hole-diameter-changing-point 9 is adjacent to the rod-diameter-changing-point 8 of the connecting element 2. In such a way, the connecting element 2 and the insulator body 3 may build a compound without free distance at both diameters.

In one aspect, the HV connector 1 further comprises an insulator ring 5 with a cone-shaped surface.

In one aspect, the insulator ring 5 with the cone-shaped surface is positioned between the rod-diameter-changing-point 8 and the hole-changing-point 9 in such a way that the insulator ring 5 is pressed between the insulator body 3 and the connecting element 2, so to tighten the compound of the insulator body 3, the insulator ring 5, and the connecting element 2.

In one aspect, the HV connector 1 further comprises a metal housing 4 surrounding the insulator body 3 at least partially.

In one aspect, the metal housing 4 has a form of a tube 48 with a rectangular spreading ring 47.

In one aspect, the inner edge of the transition from the tube 48 to the ring 47 has a radius 46 of at least 2 mm, in particular at least 3 mm.

In one aspect, the tube 48 of the metal housing 4 has an inner diameter 43 and the insulator body 3 has partially the same diameter as outer diameter so that the insulator body 3 fits tightly into the metal housing 4.

In one aspect, the insulator body 3 surrounds the inner edge of the metal housing 4 and the diameter of the insulating body 3 is rising in this region to a certain amount.

In one aspect, at least a part of the metal housing 4 is positioned in a radial plane 26 of the insulator ring 5, in such a way that the expansion of the insulator body 3 is restricted by the metal housing 4.

With "radial plane" is meant a virtual plane in which the insulator ring is placed, and which extends in radial direction from the midpoint of the insulator ring.

In this application the expression "isolating" or "insulating" shall mean electrical isolating. It should not necessarily also mean thermal isolating.

In one aspect the housing 4 comprises one, in particular few, preferred 6 or more fastening recesses 44 for fixing the connector to a cabinet of the industrial power equipment, where the HV-connecter may be arranged. This fastening recesses 44 are placed preferred at the ring 47 which spreads rectangular from the tube 48 of the metal housing 4.

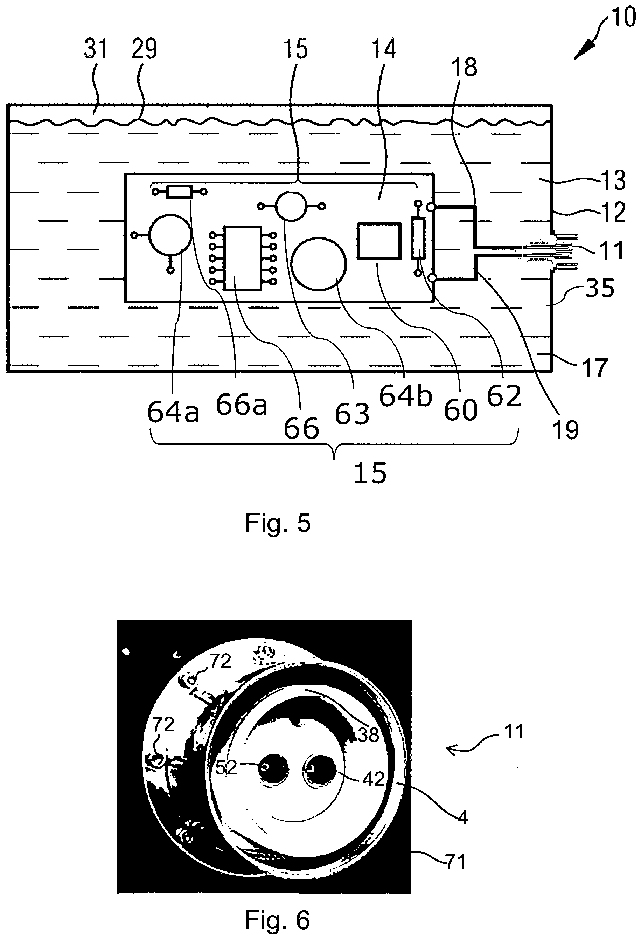

In one aspect, the HV connector 1 is mounted on a cabinet wall 71. The cabinet may comprise a container with a liquid 13. This is shown in mor detail in Fig. 5. The HV-connector may be tight against loss of the liquid 13 or vapor of the liquid, also when the pressure inside the container ay be higher as the pressure outside f the container or cabinet.

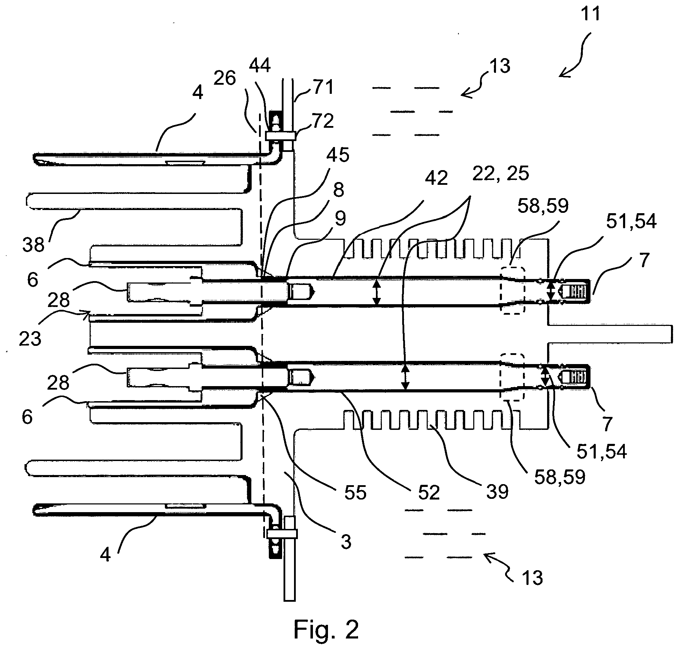

Fig. 2 shows a section view of a HV connector 11 with two connecting elements 42, 52. The same parts have the reference numbers as in the other figures.

In the aspect of Fig. 2 the mentioned connecting element 2 is a first connecting element 42, the mentioned insulator ring 5 is a first insulator ring 45, and the HV-connector comprises a second connecting element 52 and a second insulator ring 55.

So, the HV connector 11 with two connecting elements 42, 52 shall have the same behavior as the HV connector 1 with only one connecting element 2. The only difference shall be the number of the connecting elements. The HV connector may also have more than 2 conducting elements, what is not shown here.

In one aspect, the second connecting element 52 has the same features as the first connecting element 42 and the second insulator ring 55 has the same features as the first insulator ring 45.

In one aspect, the insulator body 3 is surrounding both, the first connecting element 42 and the second connecting element 52, so that both connecting elements are spaced apart from each other and are electrically insulated from each other.

In one aspect, the position of the second insulator ring 55 in respect to the second connecting element 52 is the same as the position of the first insulator ring 45 in respect to the first connecting element 42.

In one aspect, the position of the insulator body 3 in respect to the second insulator ring 55 and the second connecting element 52 is the same as the position in respect to the first insulator ring 45 and the first connecting element 42.

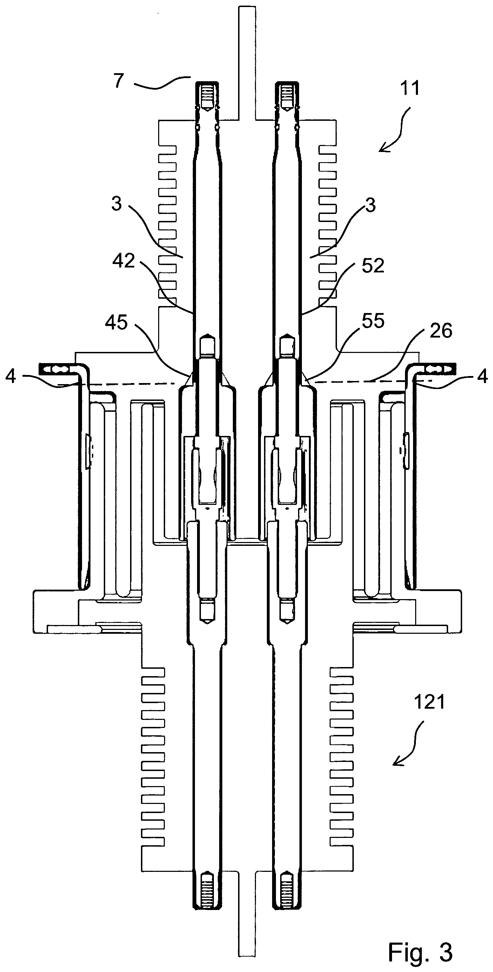

Fig. 3 shows a section view of a HV connector 11 with two connecting elements 42, 52 and a corresponding plug 121. The same parts have the reference numbers as in the other figures.

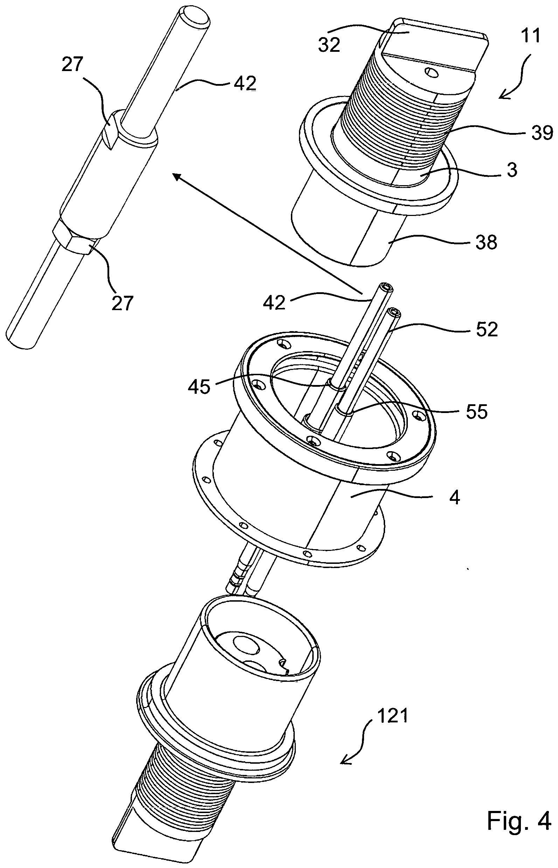

Fig. 4 shows an exploded view of a HV connector 11 with two connecting elements 42, 52 and a corresponding plug. There is also shown a partly enlarged view of the connecting element 42 with two possibilities of a rotation preventing form 27.

Fig. 5 shows an embodiment of an electronic device 10 in a schematic representation with an HV connector 11. Theis electronic device 10 may be a part of a industrial power equipment, especially in plasma process equipment.

In one aspect, the inner-end 7 is for connecting a cable or for connecting electrical circuits, e.g. inside a cabinet. The cabinet may be a cabinet of a plasma process equipment. Such a connection is shown as a first connection line 18 and a second connection line 19.

In one aspect, the cabinet may thereby be filled with a cooling liquid 13 and the connector 1,11 must ensure that no liquid or vapor of this liquid could escape on the way of the parts of the connector 1,11.

The device 10 comprises a HV connector 11 as shown in Fig. 2, a printed circuit board (PCB) 14 or a comparable carrier of electric or electronical components 15. A variety of electric or electronical components 15 are positioned on the PCB 14. Those electric or electronical components 15 could be one or several transistors 60, diodes 66a, one or several resistors 62, one or several capacitors 63, one or several inductors and/or transformers 64a, 64b, or one or more integrated circuits 66, in particular semiconductor based, such as driver circuits for the transistors 60. They are all part of the electronic device 10. In this embodiment the whole PCB 14 and all electronical components 15 are positioned inside the container 12. This is not obligatory. It is here and in all other embodiments possible, but also possible, that some of the parts 15 are outside the container 12. The container 12 may be the cabinet or a part of the cabinet.

A container 12 is filled with a liquid 13. The liquid 13 is configured as an insolating heat transfer liquid, e.g., such as disclosed by WO 2021/008949 A1 which is herewith fully incorporated by reference in its entirety.

The electronic device 10 may be any kind of electronic device that requires a high packaging density and requires direct liquid cooling. In particular, the device 10 may be a HP, HV pulsed power supply, in particular for biasing a substrate in a plasma process, such as known from EP 4 235 738 A1.

The electronic device 10 may be a part of a HP, HV pulsed power supply, in particular for biasing a substrate in a plasma process, in particular that part of such a power supply which needs cooling and insolation the most, such as: switching transistors, HV transformers, diodes, and damping circuits comprising inductivities and/or resistors, e.g..

The container 12 may be hermetically closed, so, no gas or liquid may leave. Gas solubility of cooling liquids may be controlled by the pressure of the liquid 13. The liquid extends with rising temperature. Thus, some extra volume 31 filled with a compressible medium such as gas above the top level 29 of the liquid 13 is required to allow the increase of a second volume 35 of the liquid 13.

The electrically insolating heat transfer liquid 13 is enclosed in a hermetical closed volume 17, this hermetical closed volume 17 is arranged at least partly inside the container 12 and kept in a predetermined regulated pressure range.

If the ratio of volume of the liquid 13 and the first volume 31 of the compressible medium and the pressure at a predefined temperature is chosen in a preferred way, then the following happens: If the pressure increases, also the gas solubility increases. Therefore, more gas is dissolved by the liquid 13.

The plug-connecting-end is for connecting the corresponding plug outside of the cabinet.

The connecting element may be made of any electrically conductive material such as metal, in particular copper. It may be covered with a high-quality metal, such as silver. In semiconductor factories, free copper surfaces are undesirable because copper can evaporate and poison the air cleanrooms. Therefor a diffusion barrier is favorable.

The HV-connector may be configured to withstand pulsed voltage with voltage difference of a high level of voltage, with fast switching capability and for switching frequency of about 10 kHz or more, especially 100 kHz or more, preferred 400 kHz or more.

The insulator body may be made out of a synthetic fluoropolymer such as PTFE. Despite all favorable characteristics, such a material may have the disadvantage of being very soft and to deform under pressure, one even speaks of flowing slowly away. Therefore, the the metal housing of the connector in such a way that the expansion of the insulator body is restricted by the metal housing is important.

The insulator ring may be favorable in two aspects. Firstly, it seals the contact between connecting element and insulator body. Secondly, it may help to avoid the building of electrical discharges due to the high voltage and some rest of gap between the connecting element and insulator body.

In one aspect, the aforementioned rod-diameter-changing-point 8 is a first rod-diameter-changing-point 8, and the aforementioned hole-diameter-changing-point 9 is a first hole-diameter-changing-point 9, and the connecting element 2 has a second rod-diameter-changing-point 58, where the diameter of the connecting element changes from the second rod-diameter 22 to a third rod-diameter 51 in direction to the inner-end.

In one aspect, the insulator body having a second hole-diameter-changing point 59, where the insulator-diameter of the hole 23 changes from the second hole-diameter 25 to a third hole-diameter 54 in direction to the inner-end, wherein the third hole-diameter 54 is equal to the third rod-diameter 51 , and the second rod-diameter-changing-point 58 is positioned adjacent to the second hole-diameter-changing-point 59, so that the insulator-body fits tight on the connecting element.

In one aspect, the second rod-diameter-changing-point 58 has a conus transition form the second rod-diameter 22 to the third rod-diameter 51, and the conus has an angle in the range from 3 deg to 45 deg, in particular from 7 deg to 13 deg, preferred 10 deg.

In one aspect, the second hole-diameter-changing-point 59 has a conus transition form the second hole-diameter 25 to the third hole-diameter 54, and the conus has an angle in the range from 3 deg to 45 deg, in particular from 7 deg to 13 deg, preferred 10 deg.

In one aspect, the first hole-diameter-changing-point 9 has a conus transition form the second hole-diameter 25 to the first hole-diameter 24, and the conus has an angle in the range from 3 deg to 45 deg, in particular from 10 deg to 40 deg, preferred 30 deg.

In one aspect, the insulator ring has a conus transition, and the conus has an angle in the range from 3 deg to 45 deg, in particular from 10 deg to 40 deg, preferred 30 deg.

In one aspect the HV connector comprises an O-ring positioned between the connecting element 2, 42, 52 and the insulator body 3, in particular adjacent to the inner-end 7.

In one aspect, the insulator body 3 has a ripped outer structure 39.

In one aspect, the cone-shaped surface of the insulator ring 5 is the outer surface.

In one aspect, the cone-shaped surface of the insulator ring 5 is the inner surface.

In one aspect, the edges of the metallic components have rounded edges with a radius of at least 0,5 mm.

In one aspect, the outer edges of the isolating body have rounded edges with a radius of at least 0,5 mm.

In one aspect, the insulating body 3 and the contact elements are formed in such a way that no air or liquid gap is between them both.

In one aspect, the HV-Connector 1,11 comprises a connecting pin 28 fastened into the connecting element 2, 42, 52 on the plug-connecting-end 6.

In one aspect, the connecting element 2 comprises an internal thread at the inner-end 7.

In one aspect, the insulator body comprises an isolating wall 32 between the first connecting element 42 and the second connecting element 52 at the inner-end 7.

In one aspect, the conducting element has on a point, where the insulation body surrounds the conducting element a rotation preventing element 27 and the insulating body 3 has at the same point a form which fits onto that rotation preventing element 27, so that both parts are hindered to rotate against each other.

Fig. 6 shows a view of a HV connector 11 mounted on a cabinet wall 71 of a industrial equipment.

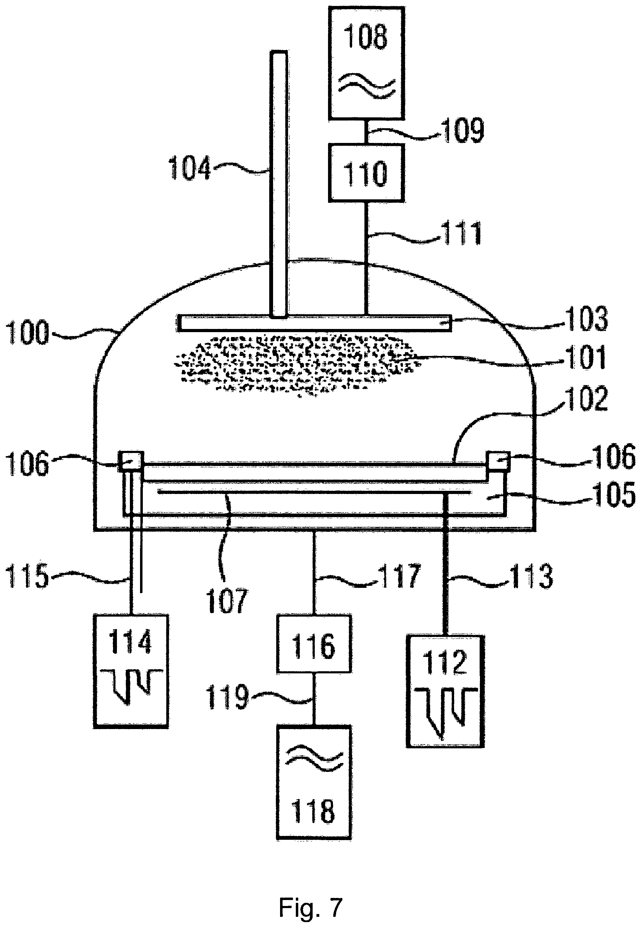

Fig. 7 shows a plasma processing system with a plasma chamber 100 in which a plasma 101 is established in a plasma space. Such or similar systems are shown and described also in EP 4 235 738 A1, e.g.. For such or a similar system the HV connector 1, 11 of this description is designed. In the plasma chamber an upper electrode 103 may be positioned. A gas inlet and/or outlet, in particular a gas supply pipe 104 may be placed from the outside to the inside of the plasma chamber 100, in particular connected to the electrode 103. A substrate 102, in particular a semiconductor wafer may be placed on a support 105 which comprises a substrate holder inside the plasma chamber 100. In use the substrate 102 may be processed by the plasma 101, e.g., in a process of etching, ashing, or deposition in particular with atomic layered deposition. Etching process may be an extremely high challenge, for instance when the ratio between etched hole diameter and hole length is extremely low, < 1/100, e.g., as it is in deep etching often necessary. An electric conductive electrode 106 may be placed in the plasma chamber 100, in particular nearby the substrate 102, for example around the substrate 102. This electric conductive electrode 106 may be an edge ring which may be also called focus ring. This electric conductive electrode 106 may be connected to a first power supply 114 via a first connection line 115. The first power supply 114 may be a DC pulsed power supply, where in particular the pulses may be of different length, different amplitude and shaped as described in US 10,474,184 B2, Fig. 2 e.g..

The first power supply 114 may be a DC pulsed power supply with two or more HV outputs, such as described in WO 2022/023422 A1, e.g. A HV connector with a first connecting element and a second connecting element is in such a case favorable.

With the control of the first power supply 114 the electric conductive electrode 106 may be used additionally or alternatively as an ion energy and/or ion acceleration direction control as also described in US 10,474,184 B2. A first radio-frequency (RF) power supply 118 may be electrically connected to the support 105 via a first power feeding rod 119 and a first matching unit 116 and a first connection unit 117. A second radio-frequency (RF) power supply 108 may be electrically connected to the upper electrode 103 via a second power feeding rod 109 and a second matching unit 110 and a second connection unit 111. An electrode 107 may be positioned in or nearby the support 105 and is electrically connected to a second power supply 112 via a second connection line 113. The second power supply 112 may be a DC pulsed power supply, where in particular the pulses may be of different length, different amplitude and shaped as described in US 10,474,184 B2, Fig. 2, e.g.. The substrate 102 may be fixed at the support 105 via the electrode 107 which may work as an electrostatic chuck. With the control of the second power supply 112, the electrode 107 may be used additionally or alternatively as an ion energy and/or ion acceleration direction control as described in US 10,474,184 B2.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required.

Some plasma applications require not only pulsing, but pulse-to-pulse amplitude variation. Some plasma applications require the source to deliver high peak currents in order to obtain short voltage transition times. Most plasma applications present a load, which contains a capacitive component. Significant power loss is related to the pulse-by-pulse charging and discharging process of this load capacitance. Some plasma applications require pulse shaping as described in US 10,474,184 B2, Fig. 2, e.g..

All described power supplies 104, 112, 114, 118 or the matching units 110, 116 may be a aforementioned industrial power equipment, in particular plasma process equipment. All such equipment may comprise an HV connector 1, 11 as described in this patent application.

## Claims

1. High voltage connector (1,11)
for an industrial power equipment configured to lead high current and withstand high voltage in particular usable for a plasma process equipment,
the HV connector (1,11) is formed to fit into a corresponding plug (121) and comprises:
- a plug-connecting-end (69 and an inner-end (7),
- a connecting element (2),
- an insulator body (3) surrounding the connecting element (2) at least partially,
- the connecting element (2) having a rod shape which expands from the plug-connecting-end (6 to an inner-end (7), the connecting element (2) comprises a rod-diameter-changing-point 8, where the diameter of the connecting element (2) changes from a first rod-diameter (21) in direction to the plug-connecting-end (6) to a second rod-diameter (22) in direction to the inner-end (7),
- the insulator body (3) having a shape with a hole (23), the hole (23) formed to surround the connecting element (2), the hole (23) having a hole-diameter-changing-point (9), where the hole-diameter of the hole (23) changes from a first hole-diameter (24) in direction to the plug-connecting-end (6) to a second hole-diameter (25) in direction to the inner-end (7), wherein the first hole-diameter (24) is equal to the first rod-diameter (21) and the second hole-diameter (25) is equal to the second rod-diameter (22), so that the insulator-body (3) fits tightly on the connecting element (2), and
- the insulator body (3) is positioned in such a way that its hole-diameter-changing-point (9) is adjacent to the rod-diameter-changing-point (8) of the connecting element (2), so that the connecting element (2) and the insulator body (3) build a compound without free distance at both diameters.

2. High voltage connector (1,11) of claim 1, further comprising:
- an insulator ring (5) with a cone-shaped surface,
- the insulator ring (5) with the cone-shaped surface is positioned between the rod-diameter-changing-point 8 and the hole-changing-point (9) in such a way that the insulator ring (5) is pressed between the insulator body (3) and the connecting element (2), so to tighten the compound of the insulator body (3), the insulator ring (5), and the connecting element (2).

3. High voltage connector (1,11) of any of the preceding claims, further comprising:
- a metal housing (4) surrounding the insulator body (3) at least partially,
- the metal housing (4) has a form of a tube (48) with a rectangular spreading ring (47) where the inner edge of the transition from the tube (48) to the ring (47) has a radius of at least 2 mm, in particular at least 3 mm.
- the tube (48 of the metal housing (4) has an inner diameter (43) and the insulator body (3) has partially the same diameter as outer diameter so that the insulator body (3) fits tightly into the metal housing (4.

4. High voltage connector (1,11) of any of the preceding claims, wherein the insulator body (3) surrounds the inner edge of the metal housing (4) and the diameter of the insulating body (3) is rising in this region to a certain amount.

5. High voltage connector (1,11) of any of the preceding claims, further comprising:
- a metal housing (4) surrounding the insulator body (3) at least partially,
- at least a part of the metal housing (4) is positioned in a radial plane (26) of the insulator ring (5), in such a way that the expansion of the insulator body (3) is restricted by the metal housing (4).

6. High voltage connector (1,11) of any of the preceding claims, wherein
- the mentioned connecting element (2) is a first connecting element (42),
- the mentioned insulator ring (5) is a first insulator ring (45), and
- the HV-connector comprises a second connecting element (52) and a second insulator ring (55),
- the second connecting element (52) having the same features as the first connecting element (42) and the second insulator ring (55) has the same features as the first insulator ring (45),
- and the insulator body (3) is surrounding both, the first connecting element (42) and the second connecting element (52), so that both connecting elements are spaced apart from each other and are electrically insulated from each other, and
- the position of the second insulator ring (55) in respect to the second connecting element (52) is the same as the position of the first insulator ring (45) in respect to the first connecting element (42),
- the position of the insulator body (3) in respect to the second insulator ring (55) and the second connecting element (52) is the same as the position in respect to the first insulator ring (45) and the first connecting element (42).

7. High voltage connector (1,11) of any of the preceding claims, wherein
- the aforementioned rod-diameter-changing-point 8 is a first rod-diameter-changing-point 8, and the aforementioned hole-diameter-changing-point 9 is a first hole-diameter-changing-point (9), and
- the connecting element (2) has a second rod-diameter-changing-point (58), where the diameter of the connecting element changes from the second rod-diameter (22) to a third rod-diameter (51) in direction to the inner-end,
- the insulator body having a second hole-diameter-changing point (59), where the insulator-diameter of the hole (23 changes from the second hole-diameter (25) to a third hole-diameter (54) in direction to the inner-end, wherein the third hole-diameter (54) is equal to the third rod-diameter (51) , and the second rod-diameter-changing-point (58) is positioned adjacent to the second hole-diameter-changing-point (59), so that the insulator-body fits tight on the connecting element.

8. High voltage connector (1,11) of any of the preceding claims, wherein the second rod-diameter-changing-point (58) has a conus transition form the second rod-diameter (22) to the third rod-diameter (51), and the conus has an angle in the range from 3 deg to 45 deg, in particular from 7 deg to 13 deg, preferred 10 deg.

9. High voltage connector (1,11) of any of the preceding claims, wherein the second hole-diameter-changing-point (59 has a conus transition form the second hole-diameter (25) to the third hole-diameter (54), and the conus has an angle in the range from 3 deg to 45 deg, in particular from 7 deg to 13 deg, preferred 10 deg.

10. High voltage connector (1,11) of any of the preceding claims, wherein the first hole-diameter-changing-point 9 has a conus transition form the second hole-diameter (2 to the first hole-diameter (2, and the conus has an angle in the range from 3 deg to 45 deg, in particular from 10 deg to $0 deg, preferred 30 deg.

11. High voltage connector (1,11) of any of the preceding claims, wherein the insulator ring has a conus transition, and the conus has an angle in the range from 3 deg to 45 deg, in particular from 10 deg to 40 deg, preferred 30 deg.

12. High voltage connector (1,11) of any of the preceding claims, wherein the HV connector comprises an O-ring (37) positioned between the connecting element (2, 42, 52) and the insulator body (3), in particular adjacent to the inner-end (7).

13. High voltage connector (1,11) of any of the preceding claims, wherein the insulator body (3) has a ripped outer structure (39).

14. High voltage connector (1,11) of any of the preceding claims, wherein the connecting element (2) comprises an internal thread at the inner-end (7).

15. High voltage connector (1,11) of any of the preceding claims, wherein the conducting element (2, 42, 52) has on a point, where the insulation body surrounds the conducting element a rotation preventing element (27) and the insulating body (3) has at the same point a form which fits onto that rotation preventing element (27), so that both parts are hindered to rotate against each other.
